# FASCICULE DE BREVET EUROPEEN

(11) **EP 3 183 749 B1**
(45) Date de publication et mention de la délivrance du brevet: **18.11.2020**
(21) Numéro de dépôt: 15759908.5
(22) Date de dépôt: 18.08.2015
(51) Int. Cl.: H01L 27/30, H01L 51/42

(54) **DISPOSITIF DE DÉTECTION D'UN RAYONNEMENT ÉLECTROMAGNÉTIQUE EN MATÉRIAUX ORGANIQUES**
VORRICHTUNG ZUR DETEKTION VON ELEKTROMAGNETISCHER STRAHLUNG AUS ORGANISCHEN MATERIALEN
DEVICE FOR DETECTING ELECTROMAGNETIC RADIATION CONSISTING OF ORGANIC MATERIALS

(30) Priorité: 19.08.2014 FR 1457870
(43) Date de publication de la demande: 28.06.2017
(73) Titulaire: ISORG, 38000 Grenoble (FR)
(72) Inventeur: BERTHOD, Emeline, F-38000 Grenoble (FR); DHEZ, Olivier, F-38000 Grenoble (FR); GOMEZ, Jean-Yves, F-38000 Grenoble (FR)
(74) Mandataire: Cabinet Beaumont
(86) Numéro de dépôt international: PCT/FR2015/052222
(87) Numéro de publication internationale: WO 2016/027033

(56) Documents cités:
- WO-A1-99/09603
- WO-A1-2010/056177
- DE-A1-102012 220 020
- GB-A- 1 106 079
- US-A1- 2003 141 498
- US-A1- 2013 076 695
- US-B1- 6 483 099
- DONG GUIFANG ET AL: "Organic photocouplers consisting of organic light-emitting diodes and organic photoresistors", APPLIED PHYSICS LETTERS, AMERICAN INSTITUTE OF PHYSICS, US, vol. 88, no. 5, 1 février 2006 (2006-02-01), pages 51110-051110, XP012082600, ISSN: 0003-6951, DOI: 10.1063/1.2171480
- V ET AL: "Adaptation to Scientific and Technical Progress under Directive 2002/95/EC - Evaluation of New Requests for Exemptions and/or Review of Existing Exemptions Öko-Institut e Fraunhofer Institute for Reliability and Microintegration IZM (subcontractor)", , 30 mai 2011 (2011-05-30), XP055187796, Extrait de l'Internet: URL:http://rohs.exemptions.oeko.info/filea dmin/user_upload/RoHS_IV/RoHS_final_report _May_2011_final.pdf [extrait le 2015-05-06]

## Description

La présente demande de brevet revendique la priorité de la demande de brevet français FR14/57870.

### Domaine

La présente demande concerne un dispositif et un procédé de détection d'un rayonnement électromagnétique, notamment de la lumière.

### Exposé de l'art antérieur

On a déjà proposé de réaliser des dispositifs de détection d'un rayonnement électromagnétique, notamment de la lumière, comprenant des composants électroniques de type transistor, diode électroluminescente et photodétecteur, à base de matériaux conducteurs et semiconducteurs organiques. Ces matériaux présentent l'avantage d'être plus faciles à déposer et moins fragiles que les matériaux conducteurs et semiconducteurs inorganiques, par exemple le silicium, utilisés dans les filières technologiques traditionnelles.

L'utilisation de matériaux organiques permet, de façon avantageuse, de réaliser le dispositif de détection sur tous types de support et en particulier sur des supports souples tels que du plastique, du papier, du carton ou du tissu, sur des supports de grandes dimensions, par exemple des panneaux publicitaires, ou sur des supports jetables tels que des emballages de produits de consommation courante.

La demande de brevet WO 2013/045779 décrit un exemple de système d'interface utilisateur comprenant un écran d'affichage et un dispositif de détection d'un organe d'actionnement comprenant une matrice de photodiodes réalisées en matériaux organiques. Chaque photodiode est associée à un transistor. Les transistors permettent de sélectionner les photodiodes lors de la commande du dispositif de détection.

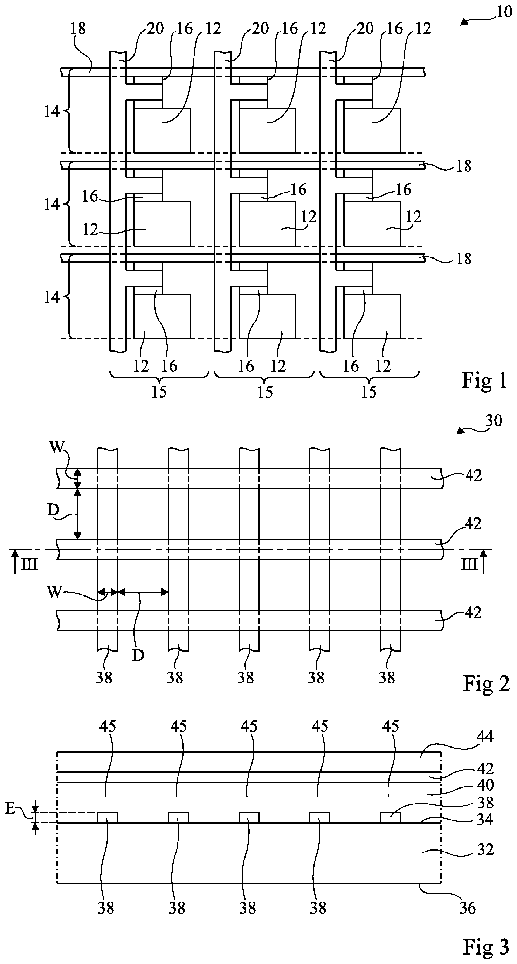

La figure 1 est une vue de dessus, partielle et schématique, d'un exemple d'un dispositif 10 de détection de lumière comprenant une matrice de photodiodes 12 réparties selon trois rangées 14 et trois colonnes 15. Un élément de sélection 16 est associé à chaque photodiode 12. Chaque photodiode 12 peut être réalisée en matériaux conducteurs et semiconducteurs organiques. L'élément de sélection 16 peut correspondre à un transistor organique (en anglais Organic Thin Film Transistor ou OTFT) . L'une des bornes parmi la source et le drain du transistor 16 est connectée à une électrode de la photodiode 12 et l'autre borne parmi la source et le drain est connectée à une piste conductrice 18. La piste conductrice 18 peut être connectée à tous les éléments de sélection 16 d'une même rangée 14. La piste 18 peut être en un matériau opaque, par exemple en métal. La grille de chaque transistor 16 peut être commandée par un signal transmis par une piste 20 d'un matériau conducteur et transparent s'étendant selon une direction perpendiculaire aux rangées 14. La piste 20 peut être connectée à tous les transistors 12 d'une même colonne 15. En figure 1, chaque transistor 16 est représenté à côté de la photodiode 12 associée. A titre de variante, chaque transistor 16 peut être formé au-dessus de la photodiode 12 associée.

On appelle surface utile d'un photodétecteur la surface du photodétecteur destinée, en fonctionnement, à être exposée au rayonnement électromagnétique à détecter. Un inconvénient du dispositif 10 est que la présence des transistors 16 entraîne une réduction de la surface utile des photodiodes 12. Un autre inconvénient est que le procédé de fabrication du dispositif de détection comprend un nombre important d'étapes, notamment les étapes de fabrication des photodiodes et les étapes de fabrication des transistors.

Le document US2003/0141498 décrit une matrice de résistances programmables comprenant chacune une portion de polymère ayant un dopant de type diphenylhydrazone monosubstitué et dont le procédé de fabrication comporte une étape d'exposition sélective de certaines portions à rayonnement UV pour ajuster la conductivité.

Le document GB1106079 décrit une matrice de photorésistances en matériau inorganique.

Le document "Organic photocouplers consisting of Organic light-emitting diode and organic photoresistor" de Dong Guifang et al. (février 2006) décrit une photorésistance comprenant un film de pentacene et des électrodes en or.

Le document US2013/076695 décrit une surface imprimée interactive

Le document WO2010/056177A1 décrit un dispositif d'affichage tactile intégré qui est actionné pour détecter l'emplacement d'un ou de plusieurs objets sur une surface tactile.

Le document DE10 2012 220 020 A1 décrit un composant optoélectronique organique comprenant un élément électroluminescent organique et un élément photodétecteur organique qui est disposé avec l'élément électroluminescent organique sur un substrat commun dans des zones surfaciques latéralement adjacentes.

### Résumé

Un objet d'un mode de réalisation est de pallier tout ou partie des inconvénients des dispositifs de détection de rayonnement électromagnétique décrits précédemment.

Un autre objet d'un mode de réalisation est d'augmenter la surface utile du dispositif de détection destinée à recevoir le rayonnement électromagnétique.

Un autre objet d'un mode de réalisation est de réduire le nombre d'étapes du procédé de fabrication du dispositif de détection.

Ainsi, un mode de réalisation prévoit un dispositif de détection d'un rayonnement électromagnétique comprenant au moins une rangée de photorésistances, chaque photorésistance comprenant une portion active comprenant des matériaux semiconducteurs organiques; des émetteurs du rayonnement électromagnétique et un guide d'onde comprenant au moins une face destinée à être en contact avec au moins un objet, les photorésistances étant réparties le long d'un bord de ladite face, les émetteurs étant répartis le long dudit bord et disposés de façon alternée avec les photorésistances.

Selon un mode de réalisation, le dispositif de détection comprend une matrice de photorésistances réparties en rangées et en colonnes.

Selon un mode de réalisation, chaque portion active est reliée à une première électrode conductrice et à une deuxième électrode conductrice.

Selon un mode de réalisation, le travail de sortie des premières électrodes conductrices est égal au travail de sortie des deuxièmes électrodes conductrices à 5 % près.

Selon un mode de réalisation, le dispositif de détection comprend une couche monolithique contenant les portions actives et s'étendant entre des premières pistes conductrices correspondant aux premières électrodes et des deuxièmes pistes conductrices correspondant aux deuxièmes électrodes.

Selon un mode de réalisation, le dispositif de détection comprend, en outre, des pixels d'affichage.

Un mode de réalisation prévoit également un système de détection comprenant le dispositif de détection défini précédemment, un circuit de sélection de l'une des photorésistances et un circuit de mesure du courant circulant dans la photorésistance sélectionnée ou d'une tension représentative de la tension aux bornes de la photorésistance sélectionnée.

Un mode de réalisation prévoit également un procédé de commande du dispositif de détection d'un rayonnement électromagnétique défini précédemment, comprenant la sélection d'une photorésistance dans ladite au moins une rangée et la détermination d'un signal représentatif de la résistance de la photorésistance.

Selon un mode de réalisation, le dispositif de détection comprend une matrice de photorésistances réparties en rangées et en colonnes, des premières pistes conductrices et des deuxièmes pistes conductrices, chaque première piste conductrice étant reliée aux photorésistances d'une même rangée et chaque deuxième piste conductrice étant reliée aux photorésistances d'une même colonne. L'étape de sélection comprend les étapes suivantes :
relier la première piste conductrice reliée à la photorésistance à sélectionner à une source d'un premier potentiel ;
relier les autres premières pistes conductrices à une source d'un deuxième potentiel différent du premier potentiel ;
relier la deuxième piste conductrice reliée à la photorésistance à sélectionner à la source du deuxième potentiel ; et
relier les autres deuxièmes pistes conductrices à la source du premier potentiel.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une vue de dessus, partielle et schématique, d'un exemple d'un dispositif de détection de rayonnement comprenant une matrice de photodiodes ;
la figure 2 est une vue de dessus, partielle et schématique, d'un mode de réalisation d'un dispositif de détection de rayonnement ;
la figure 3 est une vue en coupe, partielle et schématique, de la figure 2 selon la ligne III-III ;
les figures 4A à 4C sont des vues en coupe, partielles et schématiques, de structures obtenues à des étapes successives d'un mode de réalisation d'un procédé de fabrication du dispositif de détection de rayonnement de la figure 2 ;
la figure 5 est une vue en coupe d'un autre mode de réalisation d'un dispositif de détection de rayonnement ;
la figure 6 est un schéma électrique d'un mode de réalisation d'un système de détection de lumière comprenant le dispositif de détection représenté en figure 2 ;
les figures 7 et 8 sont des vues en coupe représentant d'autres modes de réalisation du dispositif de détection ; et
la figure 9 est une vue en perspective, partielle et schématique, d'un mode de réalisation du dispositif de détection selon l'invention.

### Description détaillée

Par souci de clarté, de mêmes éléments ont été désignés par de mêmes références aux différentes figures et, de plus, les diverses figures ne sont pas tracées à l'échelle. En outre, seuls les éléments utiles à la compréhension des modes de réalisation ont été représentés et sont décrits. En particulier, les moyens de traitement des signaux fournis par les dispositifs de détection décrits ci-après sont à la portée de l'homme de l'art et ne sont pas décrits. Dans la suite de la description, sauf indication contraire, les termes "sensiblement", "environ" et "de l'ordre de" signifient "à 10 % près".

Un mode de réalisation prévoit un dispositif de détection d'un rayonnement électromagnétique, notamment dans une plage de longueurs d'onde comprises entre 400 nm et 1000 nm, comprenant une matrice de photodétecteurs en matériaux organiques dans lequel chaque photodétecteur comprend une photorésistance. La matrice comprend au moins une rangée de plusieurs photorésistances. Chaque photorésistance comprend une portion active, comportant un ou plusieurs matériaux semiconducteurs organiques, prise en sandwich entre deux électrodes conductrices. Le dispositif de détection ne comprend pas de transistor de sélection pour chaque photodétecteur. La surface utile de chaque photodétecteur peut être augmentée par rapport à un dispositif de détection comprenant une matrice de photodiodes organiques et de transistors de sélection. En particulier, les photodétecteurs peuvent être jointifs et la surface utile du photodétecteur peut s'étendre sur la totalité du dispositif de détection. En outre, la structure du dispositif de détection est plus simple que celle d'un dispositif de détection comprenant une matrice de photodiodes organiques, chaque photodiode étant associée à un transistor de sélection. Le procédé de fabrication du dispositif de détection est simplifié. En effet, il comprend seulement les étapes de fabrication de la matrice de photorésistances.

Les figures 2 et 3 représentent un mode de réalisation d'un dispositif 30 de détection d'un rayonnement électromagnétique, notamment de la lumière.

Le dispositif 30 comprend successivement du bas vers le haut en figure 3 :
un support 32 comprenant deux faces 34, 36 opposées ;
des premières électrodes 38, correspondant à des pistes conductrices 38 s'étendant sur la face 34 du substrat 32, par exemple de façon sensiblement parallèle à une première direction ;
une couche active 40 recouvrant les pistes conductrices 38 et les parties exposées du substrat 32 entre les pistes conductrices 38 ;
des deuxièmes électrodes 42, correspondant à des pistes conductrices 42 s'étendant sur la couche active 40, par exemple de façon sensiblement parallèle à une deuxième direction inclinée par rapport à la première direction, de préférence sensiblement perpendiculaire à la première direction ; et
une couche de protection 44 recouvrant les pistes conductrices 42 et les parties exposées de la couche 40 entre les pistes conductrices 42.

Le support 32 peut être en un matériau diélectrique. Le support 32 est, par exemple, un support rigide, notamment en verre ou un support flexible, par exemple en polymère ou en un matériau métallique. Des exemples de polymère sont le polyéthylène naphtalène (PEN), le polyéthylène téréphtalate (PET), le kapton, et le polyétheréthercétone (PEEK). L'épaisseur du support 32 est, par exemple, comprise entre 20 µm et 1 cm, par exemple environ 125 µm. Le support 32 peut être en un matériau transparent ou translucide, par exemple en verre ou en plastique, notamment dans le cas où le dispositif 30 est destiné à recevoir un éclairement du côté de la face 36.

Les pistes conductrices 38 ou 42 peuvent être en un matériau conducteur et transparent, par exemple en oxyde conducteur et transparent ou TCO (acronyme anglais pour Transparent Conductive Oxide), en nanotubes de carbone, en graphène, en un polymère conducteur, en un métal, ou en un mélange ou un alliage d'au moins deux de ces composés. Les pistes conductrices 38 ou 42 peuvent avoir une structure multicouche.

Des exemples de TCO adaptés à la réalisation des pistes conductrices 38 ou 42 sont l'oxyde d'indium-étain (ITO, de l'anglais Indium Tin Oxide), l'oxyde d'aluminium-zinc (AZO, de l'anglais Aluminium Zinc Oxide) et l'oxyde de gallium-zinc (GZO, de l'anglais Gallium Zinc Oxide). Des exemples de polymères conducteurs adaptés à la réalisation des pistes conductrices 38 ou 42 sont le polymère connu sous la dénomination PEDOT:PSS, qui est un mélange de poly(3,4)-éthylènedioxythiophène et de polystyrène sulfonate de sodium et le polyaniline, également appelé PAni. Des exemples de métaux adaptés à la réalisation des pistes conductrices 38 ou 42 sont l'argent (Ag), l'aluminium (Al), l'or (Au), le cuivre (Cu), le nickel (Ni), le titane (Ti) et le chrome (Cr). Un exemple de structure multicouche adaptée à la réalisation des électrodes est une structure multicouche d'AZO et d'argent de type AZO/Ag/AZO.

L'épaisseur E des pistes conductrices 38 ou 42 peut être comprise entre 10 nm et 5 µm, par exemple de l'ordre de 30 nm. Ces couches peuvent être déposées par un procédé de dépôt sous vide, notamment par évaporation ou pulvérisation, par un procédé de dépôt par voie liquide, notamment un procédé sol-gel, un procédé utilisant des dispersions ou des nanoparticules, ou par tout autre type de procédé de dépôt. Dans le cas où les pistes conductrices 38 et/ou les pistes conductrices 42 sont métalliques et doivent être au moins partiellement transparentes, l'épaisseur des pistes conductrices 38 et/ou 42 est inférieure ou égale à 20 nm, de préférence inférieure ou égale à 10 nm. Selon un mode de réalisation, la largeur W de chaque piste 38 ou 42 peut être comprise entre 5 µm et 150 µm, de préférence entre 7 µm et 100 µm, par exemple environ 20 µm. L'écart D entre deux pistes 38 adjacentes ou entre deux pistes 42 adjacentes peut être compris entre 15 µm et 100 µm, de préférence entre 20 µm et 50 µm, par exemple environ 25 µm.

Selon un mode de réalisation, le travail de sortie du matériau des pistes conductrices 38 est égal au travail de sortie du matériau des pistes conductrices 42 à 5 % prés. De préférence, les pistes conductrices 38, 42 sont réalisées dans le même matériau ou les mêmes matériaux.

La résistivité électrique de la couche active 40 peut varier localement. Elle dépend localement de l'intensité du rayonnement électromagnétique reçu par la couche active 40 dans une plage de longueurs d'onde comprise entre 400 nm et 1000 nm, de préférence entre 480 nm et 680 nm.

La couche active 40 peut comprendre des petites molécules, des oligomères ou des polymères. Il peut s'agir de matériaux organiques ou inorganiques. La couche active 40 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la couche active 40 peut être comprise entre 50 nm et 500 nm, par exemple de l'ordre de 200 nm.

Des exemples de polymères semiconducteurs de type P adaptés à la réalisation de la couche active 40 sont le poly(3-hexylthiophène) (P3HT), le poly[N-9'-heptadécanyl-2,7-carbazole-alt-5,5-(4,7-di-2-thiényl-2',1',3'-benzothiadiazole] (PCDTBT), le poly[(4,8-bis-(2-éthylhexyloxy)-benzo[1,2-b;4,5-b'] dithiophène)-2,6-diyl-alt-(4-(2-éthylhexanoyl)-thie-no[3,4-b] thiophène))-2,6-diyl]; 4,5-b']dithi-ophène)-2,6-diyl-alt-(5,5'-bis(2-thiényl)-4,4,-dinonyl-2,2'-bithiazole)-5',5"-diyl] (PBDTTT-C), le poly[2-méthoxy-5-(2-éthyl-hexyloxy)-1,4-phénylène-vinylène] (MEH-PPV) ou le poly[2,6-(4,4-bis-(2-éthylhexyl)-4H-cyclopenta [2,1-b;3,4-b']dithiophène)-*alt*-4,7(2,1,3-benzothiadiazole)] (PCPDTBT).

Des exemples de matériaux semiconducteurs de type N adaptés à la réalisation de la couche active 40 sont les fullerènes, notamment le C60, le [6,6]-phényl-C₆₁-butanoate de méthyle ([60]PCBM), le [6,6]-phényl-C₇₁-butanoate de méthyle ([70]PCBM), le pérylène diimide, l'oxyde de zinc (ZnO) ou des nanocristaux permettant la formation de boîtes quantiques (en anglais quantum dots).

La couche de protection 44 peut être en un matériau diélectrique, par exemple une résine. La couche de protection 44 peut avoir une épaisseur comprise entre 1 µm et 100 µm, par exemple environ 50 pm. Dans le cas où le support 32 est en un matériau transparent, la couche de protection 44 peut être identique au support 32. La couche de protection 44 peut avoir une structure monocouche ou une structure multicouche.

Dans le cas où le dispositif 30 est destiné à recevoir un éclairement du côté de la face 36, le support 32 et les pistes conductrices 38 sont en des matériaux au moins en partie transparents. Dans le cas où le dispositif 30 est destiné à recevoir un éclairement du côté de la couche de protection 44, la couche de protection 44 et les pistes conductrices 42 sont en des matériaux au moins en partie transparents. Dans le cas où le dispositif 30 est destiné à recevoir un éclairement indifféremment du côté de la face 36 ou du côté de la couche de protection 44, le support 32, les pistes conductrices 38 et 42 et la couche de protection 44 sont en des matériaux au moins en partie transparents.

Le dispositif de détection 30 comprend une matrice de photorésistances 45. Chaque photorésistance 45 associée à une piste conductrice 38 et à une piste conductrice 42 correspond à la portion de la couche active 40 dans laquelle va circuler un courant lorsqu'une tension est appliquée entre les pistes conductrices 38 et 42. Cette portion s'étend entre la piste conductrice 38 et la piste conductrice 42 au chevauchement entre la piste conductrice 38 et la piste conductrice 42 et peut s'étendre latéralement de part et d'autre des pistes conductrices 38, 42.

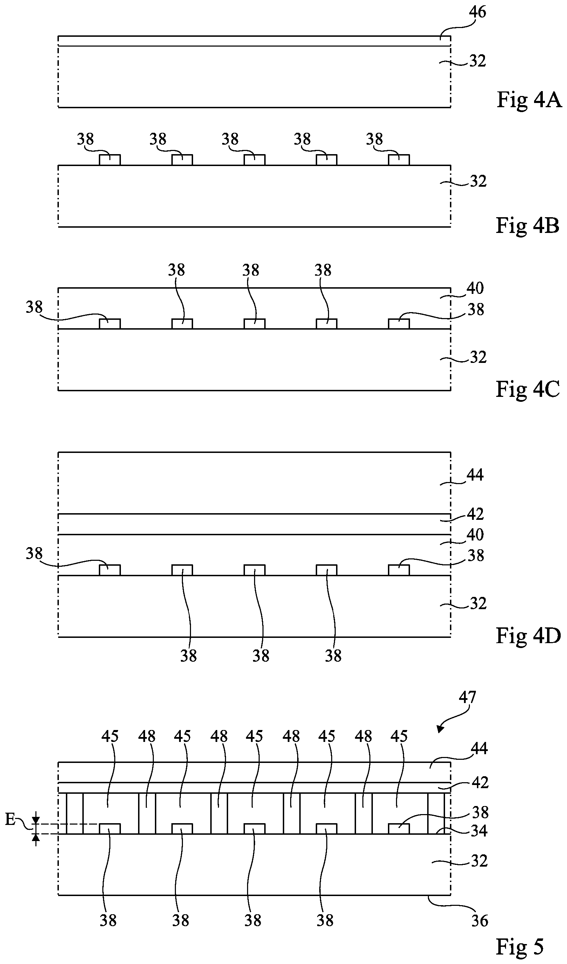

Les figures 4A à 4D illustrent un mode de réalisation d'un procédé de fabrication du dispositif 30 comprenant les étapes suivantes :
- formation des pistes conductrices 38 sur le support 32. Selon le matériau utilisé, le procédé de formation des pistes conductrices 38 peut correspondre à un procédé dit additif, par exemple par dépôt direct du matériau composant les pistes conductrices 38 aux emplacements souhaités. Ce matériau est notamment obtenu selon un procédé sol-gel. Le dépôt peut être réalisé par impression par jet d'encre, héliographie, sérigraphie, flexographie, revêtement par pulvérisation (en anglais spray coating) ou dépôt de gouttes (en anglais drop-casting). Le procédé de formation des pistes conductrices 38 peut correspondre à un procédé dit soustractif, dans lequel une couche 46 du matériau composant les pistes conductrices 38 est déposée sur la totalité de la structure (figure 4A) et dans lequel les portions non utilisées sont ensuite retirées, par exemple par photolithographie ou ablation laser (figure 4B) . Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Lorsque les pistes conductrices 38 sont métalliques, le métal est, par exemple, déposé par évaporation ou par pulvérisation cathodique sur l'ensemble du support 32 et les pistes conductrices 38 sont délimitées par gravure.
- formation de la couche active 40 (figure 4C) . La couche active 40 peut être réalisée, en fonction des matériaux utilisés, selon tout ou partie des procédés décrits précédemment pour la formation des pistes conductrices 38 ;
- formation des pistes conductrices 42 sur un autre support supplémentaire 44 de façon analogue à la formation des pistes conductrices 38 sur le support 32 ; et
- fixation de l'ensemble pistes conductrices 42/support 44 sur la couche active 44, par exemple en utilisant un matériau de collage conducteur (figure 4D).

Selon un autre mode de réalisation du procédé de fabrication du dispositif de détection 30, après l'étape de formation de la couche active 40, le procédé comprend les étapes suivantes :
- formation des pistes conductrices 42 sur la couche active 40 ; et
- formation de la couche de protection 44 sur les portions conductrices 42 et sur les parties de la couche active 40 entre les pistes conductrices 42.

De façon avantageuse, le dispositif de détection 30 peut être réalisé par des techniques d'impression. Les matériaux des couches 38, 40, 42 décrites précédemment peuvent être déposés sous forme liquide, par exemple sous forme d'encres conductrices et semiconductrices à l'aide d'imprimantes à jet d'encre. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150°C, et le dépôt et les éventuels recuits peuvent être réalisés à la pression atmosphérique.

La figure 5 représente un autre mode de réalisation d'un dispositif de détection 47 comprenant les mêmes éléments que le dispositif de détection 30 à la différence que chaque photorésistance 45 correspond à une portion active distincte. Les portions actives 45 sont séparées les unes des autres par des portions isolantes 48.

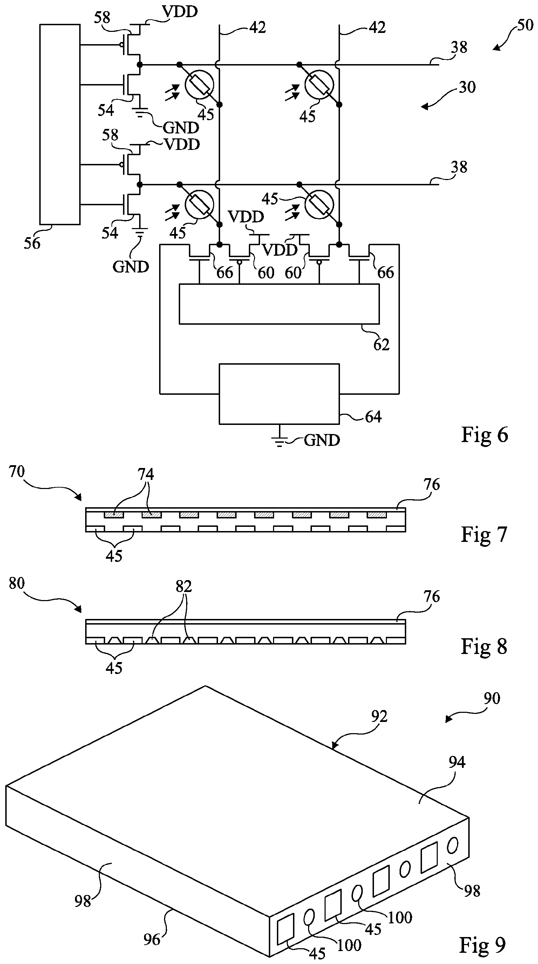

La figure 6 représente un mode de réalisation d'un système 50 de détection d'un rayonnement électromagnétique, notamment de la lumière, comprenant le dispositif de détection 30. On a représenté de façon schématique le dispositif de détection 30 par une matrice de photorésistances 45. A titre d'exemple, quatre photorésistances réparties selon deux rangées et deux colonnes sont représentées. Chaque photorésistance 45 est connectée à l'une des pistes conductrices 38 et à l'une des pistes conductrices 42. En figure 6, on a représenté de façon schématique deux pistes conductrices 38 orientées selon les rangées et deux pistes conductrices 42 orientées selon les colonnes.

Chaque piste conductrice 38 est reliée à une source d'un potentiel de référence bas, par exemple la masse GND, par l'intermédiaire d'un interrupteur 54. Les interrupteurs 54 sont commandés par un module 56 de sélection de rangée. A titre d'exemple, chaque interrupteur 54 correspond à un transistor à effet de champ à grille métal-oxyde, ou transistor MOS, par exemple à canal N, dont le drain est relié à la piste conductrice 38, dont la source est reliée à la masse GND et dont la grille est commandée par le module 56. Chaque piste conductrice 38 est reliée à une source d'un potentiel de référence haut VDD par l'intermédiaire d'un interrupteur 58. Les interrupteurs 58 sont commandés par le module 56 de sélection de rangée. A titre d'exemple, chaque interrupteur 58 correspond à un transistor MOS, par exemple à canal P, dont le drain est relié à la piste conductrice 38, dont la source est reliée à la source de potentiel VDD et dont la grille est commandée par le module 56.

Chaque piste conductrice 42 est reliée à la source de potentiel VDD par l'intermédiaire d'un interrupteur 60. Les interrupteurs 60 sont commandés par un module 62 de sélection de colonne. A titre d'exemple, chaque interrupteur 60 correspond à un transistor MOS, par exemple à canal P, dont le drain est relié à la piste conductrice 42, dont la source est reliée à la source de potentiel VDD et dont la grille est commandée par le module 62. Chaque piste conductrice 42 est reliée à la masse GND par un interrupteur 66. Un circuit de mesure de courant 64 est adapté à mesurer le courant circulant dans chaque piste conductrice 42 lorsque celle-ci est reliée à la masse GND. Les interrupteurs 66 sont commandés par le module 62 de sélection de colonne. A titre d'exemple, chaque interrupteur 66 correspond à un transistor MOS, par exemple à canal N, dont le drain est relié à la piste conductrice 42, dont la source est reliée au circuit de mesure 64 et dont la grille est commandée par le module 62.

Le fonctionnement du mode de réalisation du système de détection 50 comprend la sélection d'une photorésistance 45. Ceci peut être réalisé de la façon suivante :
pour la rangée de la photorésistance 45 sélectionnée, la piste conductrice 38 est reliée à la source de potentiel VDD par la fermeture de l'interrupteur 58 associé, l'interrupteur 54 associé étant maintenu ouvert ;
pour les autres rangées, mise des pistes conductrices 38 à la masse GND par la fermeture des interrupteurs 54 associés, les interrupteurs 58 associés étant maintenus ouverts ;
pour la colonne de la photorésistance 45 sélectionnée, la piste conductrice 42 est reliée au circuit de mesure 64 par la fermeture de l'interrupteur 66 associé, l'interrupteur 60 associé étant maintenu ouvert ; et
pour les autres colonnes, les pistes conductrices 42 sont reliées à la source de potentiel VDD par la fermeture des interrupteurs 60, les interrupteurs 66 étant maintenus ouverts.

Pour la photorésistance 45 sélectionnée, un courant circule dans la photorésistance 45 dont l'amplitude varie en fonction de la résistance de la photorésistance 45 et donc en fonction de l'éclairement reçu par la photorésistance 45. Pour les autres photorésistances 45 de la même rangée que la photorésistance 45 sélectionnée, les deux bornes des photorésistances sont reliées à la source de potentiel VDD de sorte qu'aucun courant ne circule dans ces photorésistances 45. Pour les autres photorésistances 45 de la même colonne que la photorésistance 45 sélectionnée, les deux bornes des photorésistances sont reliées à la masse GND de sorte qu'aucun courant ne circule dans ces photorésistances 45. Le circuit de mesure 64 est adapté à mesurer le courant traversant la photorésistance 45 sélectionnée. La résistance de la photorésistance 45 sélectionnée peut être déterminée à partir de la détermination du courant traversant la photorésistance 45 et de la connaissance de la tension aux bornes de la photorésistance 45 sélectionnée.

Selon un autre mode de réalisation, le système de détection de lumière peut comprendre la circulation d'un courant constant dans la photorésistance sélectionnée et la mesure d'une tension représentative de la tension aux bornes de la photorésistance sélectionnée. La tension mesurée est fonction de la résistance de la photorésistance et donc de l'éclairement reçu par la photorésistance.

Le dispositif de détection 30 peut être utilisé comme dispositif d'interface utilisateur adapté à détecter des variations de l'ombre d'un organe d'actionnement sur la matrice de photorésistances et/ou des variations de l'image réfléchie, par exemple dans l'infrarouge, de l'organe d'actionnement et à en déduire une information représentative d'une variation de position de l'organe d'actionnement. L'organe d'actionnement peut être un doigt de l'utilisateur, sa main, ou tout autre objet.

On note que par position de l'organe d'actionnement on entend ici une position relative par rapport au dispositif d'interface. On peut notamment prévoir un mode d'utilisation dans lequel c'est le dispositif d'interface utilisateur lui-même qui est déplacé, l'organe d'actionnement restant fixe.

Selon un mode de réalisation, le dispositif d'interface est adapté à détecter des variations de l'ombre de l'organe d'actionnement sur la matrice de photorésistances lorsque l'organe d'actionnement est disposé entre une source lumineuse et la matrice. La source de lumière est de préférence la lumière ambiante, par exemple le soleil ou l'éclairage électrique intérieur d'une pièce d'un bâtiment. Selon un mode de réalisation, l'organe d'actionnement peut être au contact du dispositif d'interface. Selon un mode de réalisation, l'organe d'actionnement peut être à distance du dispositif d'interface et le dispositif d'interface utilisateur peut être adapté à détecter des déplacements de l'organe d'actionnement dans un plan parallèle au plan de la matrice de photorésistances, et des variations de la distance entre l'organe d'actionnement et la matrice de photorésistances.

La figure 7 est une vue en coupe représentant un autre mode de réalisation d'un dispositif d'interface utilisateur 70 comprenant une matrice de photorésistances 45, notamment telles que celles du dispositif de détection 47 décrit précédemment, associée à un écran d'affichage. Ceci permet notamment de réaliser une interface interactive. Le dispositif 70 comprend une matrice de pixels 74 d'affichage lumineux (ou de rétro-éclairage). Dans cet exemple, les pixels 74, par exemple des diodes électroluminescentes, sont disposés dans un plan parallèle à la matrice de photorésistances 45, et entre la matrice de photorésistances et un revêtement de protection 76. La matrice de photorésistances 45 et la matrice de pixels 74 sont superposées avec un léger décalage de façon que, en vue de dessus, les pixels 74 ne soient pas en regard des photorésistances 45, ce qui masquerait les photorésistances 45 et empêcherait la détection de l'ombre portée de l'organe d'actionnement.

Dans une variante de réalisation, la matrice de photorésistances 45 est placée entre la matrice de pixels d'affichage 74 et le revêtement de protection 76. Dans ce cas, on peut prévoir de superposer les photorésistances 45 et les pixels 76 sans décalage, à condition que les photorésistances 45 soient réalisées en des matériaux transparents ou translucides.

Dans une autre variante de réalisation, les matrices de détection et d'affichage ne sont pas superposées, mais sont réalisées dans un même niveau de l'empilement de couches conductrices et semiconductrices (alternance de pixels 74 et de photorésistances 45).

On note que l'écran d'affichage associé au dispositif d'interface 70 n'est pas nécessairement un écran à diodes électroluminescentes, mais peut être réalisé dans toute autre technologie adaptée.

De plus, dans une autre variante de réalisation, l'écran d'affichage n'est pas superposé au dispositif d'interface utilisateur mais est déporté.

La figure 8 est une vue en coupe représentant une autre variante de réalisation d'un dispositif d'interface 80 comprenant, en plus des photorésistances 45, une matrice d'émetteurs infrarouge 82. Chaque photorésistance 45 a alors sa résistance qui dépend du rayonnement infrarouge reçu. En fonctionnement, chacun des émetteurs 82 émet en permanence un rayonnement infrarouge. Lorsque l'organe d'actionnement survole un émetteur 82, une partie du rayonnement émis est réfléchie vers une photorésistance voisine, ce qui permet d'en déduire une information relative à la présence d'un objet au-dessus de l'interface. Ainsi, les émetteurs infrarouge 82, en combinaison avec les photorésistances 45, permettent au dispositif 80 de mettre en oeuvre les mêmes fonctions de détection des variations de position de l'organe d'actionnement que les photorésistances 45 seules utilisées comme détecteurs d'ombrage.

Un avantage de la détection infrarouge par rapport à la détection d'ombrage est que son fonctionnement est indépendant de l'éclairage ambiant et donc plus robuste. En particulier, la détection infrarouge peut fonctionner dans l'obscurité, en l'absence d'une source de lumière extérieure. On peut prévoir d'alterner entre un mode de fonctionnement basse consommation, basé sur la détection de l'ombre portée de l'organe d'actionnement par les photorésistances 45 lorsque l'éclairage ambiant le permet, et un mode de fonctionnement infrarouge lorsque les conditions d'éclairement ne permettent pas la détection d'ombre portée. On peut par exemple prévoir un capteur de pénombre pour passer automatiquement du mode basse consommation au mode infrarouge lorsque la luminosité ambiante devient trop faible pour permettre la détection d'ombre portée.

La figure 9 représente un mode de réalisation d'un dispositif de détection 90 selon l'invention dans lequel le dispositif de détection 90 comprend un guide d'onde 92 comprenant deux faces 94, 96 opposées et des bords 98. Le long de l'un des bords 98 du guide d'onde 92, le dispositif de détection 90 comprend des photorésistances 45, notamment telles que celles du dispositif de détection 47 décrit précédemment, et des émetteurs de lumière 100. A titre d'exemple, en figure 9, une seule rangée de photorésistances 45 est représentée.

La lumière émise par les émetteurs 100 est guidée dans le guide d'onde 92 en se réfléchissant sur les faces 94, 96 et les bords 98 et au moins une partie de cette lumière revient vers les photorésistances 45. Lorsqu'un objet est posé sur l'une des faces 94, 96 du guide d'onde 92, il perturbe le parcours de la lumière de sorte que l'intensité lumineuse reçue par les photorésistances diminue. Le dispositif de détection 90 peut être utilisé pour détecter la présence ou l'absence d'un ou de plusieurs objets sur l'une des faces 94, 96 ou les dimensions d'un objet présent sur l'une des faces 94, 96.

Selon un exemple d'application, le dispositif de détection 90 peut être disposé dans un étalage d'un magasin ou d'un entrepôt, les articles étant posés sur l'une des faces 94 ou 96 du guide d'onde 92. Le dispositif de détection 90 peut être utilisé pour détecter le taux de remplissage de l'étalage. En effet, l'intensité lumineuse reçue par les photorésistances 45 dépend du nombre d'articles présents sur le guide d'onde 92. De plus, par calibration, il peut être possible de distinguer le cas où un article n'est pas posé de façon correcte sur le guide d'onde 92 mais est tombé sur le guide d'onde 92.

Selon un autre exemple d'application, le dispositif de détection 90 peut former le fond d'une boîte dans laquelle sont cultivés des micro-organismes, des bactéries ou des cellules d'organismes supérieurs, par exemple une boîte de Pétri, qui au fur et à mesure de leur croissance forment des taches recouvrant le guide d'onde 92 et modifiant l'intensité lumineuse reçue par les photorésistances 45. Le dispositif de détection 90 permet alors de mesurer la croissance des organismes cultivés.

Le dispositif de détection comprenant des photorésistances selon les modes de réalisation décrits précédemment a une structure plus simple qu'un dispositif de détection comprenant des photodiodes. En effet, dans le cas d'un dispositif de photodétection comprenant une matrice de photodiodes en matériaux organiques, chaque photodiode comprend une couche active, une première couche d'interface interposée entre la couche active et une première électrode et une deuxième couche d'interface interposée entre la couche active et une deuxième électrode. La première couche d'interface permet d'aligner le travail de sortie de la première électrode avec l'affinité électronique du matériau accepteur utilisé dans la couche active. La deuxième couche d'interface permet d'aligner le travail de sortie de la deuxième électrode avec le potentiel d'ionisation du matériau donneur utilisé dans la couche active. Suivant le mode de polarisation de la diode, les couches d'interface facilitent la collection, l'injection ou le blocage des charges depuis les électrodes dans la couche active. De façon avantageuse, le dispositif de détection comprenant des photorésistances selon les modes de réalisation décrits précédemment ne comprend pas ces couches d'interface.

## Revendications

1. Dispositif de détection (90) d'un rayonnement électromagnétique comportant :
au moins une rangée de photorésistances (45), chaque photorésistance comprenant une portion active comprenant des matériaux semiconducteurs organiques ;
des émetteurs (100) du rayonnement électromagnétique et un guide d'onde (92) comprenant au moins une face (94) destinée à être en contact avec au moins un objet, les photorésistances (45) étant réparties le long d'un bord (98) de ladite face,
**caractérisé en ce que** les émetteurs sont répartis le long dudit bord et disposés de façon alternée avec les photorésistances.

2. Dispositif de détection selon la revendication 1, comprenant une matrice de photorésistances (45) réparties en rangées et en colonnes.

3. Dispositif de détection selon la revendication 1 ou 2, dans lequel chaque portion active (45) est reliée à une première électrode conductrice (38) et à une deuxième électrode conductrice (42) .

4. Dispositif de détection selon la revendication 3, dans lequel le travail de sortie des premières électrodes conductrices (38) est égal au travail de sortie des deuxièmes électrodes conductrices (42) à 5 % près.

5. Dispositif de détection selon l'une quelconque des revendications 1 à 4, comprenant une couche monolithique (40) contenant les portions actives et s'étendant entre des premières pistes conductrices (38) correspondant aux premières électrodes et des deuxièmes pistes conductrices (42) correspondant aux deuxièmes électrodes.

6. Dispositif de détection selon l'une quelconque des revendications 1 à 5, comprenant, en outre, des pixels d'affichage (74) .

7. Système de détection (50) comprenant le dispositif de détection (90) selon l'une quelconque des revendications 1 à 6, un circuit (56, 62) de sélection de l'une des photorésistances (45) et un circuit (64) de mesure du courant circulant dans la photorésistance sélectionnée ou d'une tension représentative de la tension aux bornes de la photorésistance sélectionnée.

8. Procédé de commande du dispositif de détection (90) d'un rayonnement électromagnétique selon l'une quelconque des revendications 1 à 6, comprenant la sélection d'une photorésistance (45) dans ladite au moins une rangée et la détermination d'un signal représentatif de la résistance de la photorésistance.

9. Procédé de commande selon la revendication 8, dans lequel le dispositif de détection comprend une matrice de photorésistances (45) réparties en rangées et en colonnes, des premières pistes conductrices (38) et des deuxièmes pistes conductrices (42), chaque première piste conductrice étant reliée aux photorésistances d'une même rangée et chaque deuxième piste conductrice étant reliée aux photorésistances d'une même colonne, et dans lequel l'étape de sélection comprend les étapes suivantes :
relier la première piste conductrice reliée à la photorésistance à sélectionner à une source d'un premier potentiel (VDD) ;
relier les autres premières pistes conductrices à une source d'un deuxième potentiel (GND) différent du premier potentiel ;
relier la deuxième piste conductrice reliée à la photorésistance à sélectionner à la source du deuxième potentiel ; et
relier les autres deuxièmes pistes conductrices à la source du premier potentiel.

## Patentansprüche

1. Eine elektromagnetische Strahlungsdetektionseinrichtung (90), die Folgendes aufweist:
mindestens eine Reihe von Fotowiderständen (45), wobei jeder Fotowiderstand einen aktiven Teil mit organischen Halbleitermaterialien aufweist;
Emitter (100) der elektromagnetischen Strahlung und einen Wellenleiter (92), der mindestens eine Oberfläche (94) aufweist, die dazu bestimmt ist, mit mindestens einem Objekt in Kontakt zu sein, wobei die Fotowiderstände (45) entlang einer Kante (98) dieser Oberfläche verteilt sind,
**dadurch gekennzeichnet, dass** die Emitter entlang dieser Kante verteilt sind und abwechselnd mit den Fotowiderständen angeordnet sind.

2. Detektionseinrichtung nach Anspruch 1, die eine Anordnung von Fotowiderständen (45), die in Zeilen und Spalten verteilt sind, aufweist.

3. Detektionseinrichtung nach Anspruch 1 oder 2, wobei jeder aktive Teil (45) mit einer ersten leitenden Elektrode (38) und mit einer zweiten leitenden Elektrode (42) verbunden ist.

4. Detektionseinrichtung nach Anspruch 3, wobei die Arbeitsfunktion der ersten leitenden Elektroden (38) der Arbeitsfunktion der zweiten leitenden Elektroden (42) mit einer Genauigkeit von 5% entspricht.

5. Detektionseinrichtung nach einem der Ansprüche 1 bis 4, die eine monolithische Schicht (40) aufweist, die die aktiven Abschnitte aufweist und sich zwischen ersten leitenden Bahnen (38), die den ersten Elektroden entsprechen, und zweiten leitenden Bahnen (42), die den zweiten Elektroden entsprechen, erstreckt.

6. Detektionseinrichtung nach einem der Ansprüche 1 bis 5, die weiter Anzeigepixel (74) aufweist.

7. Ein Detektionssystem (50), welches die Detektionseinrichtung (90) nach einem der Ansprüche 1 bis 6, eine Schaltung (56, 62) zum Auswählen eines der Fotowiderstände (45) und eine Schaltung (64) zum Messen des durch den ausgewählten Fotowiderstand fließenden Stroms oder einer für die Spannung über dem ausgewählten Fotowiderstand repräsentativen Spannung aufweist.

8. Ein Verfahren zum Steuern der elektromagnetischen Strahlungsdetektionseinrichtung (90) nach einem der Ansprüche 1 bis 6, wobei das Verfahren Auswählen eines Fotowiderstandes (45) aus der mindestens einen Reihe und Bestimmen eines Signals, das für den Widerstand des Fotowiderstandes repräsentativ ist, aufweist.

9. Verfahren zum Steuern nach Anspruch 8, wobei die Detektionseinrichtung eine Anordnung von Fotowiderständen (45), verteilt in Zeilen und Spalten, erste leitende Bahnen (38) und zweite leitende Bahnen (42) aufweist, wobei jede erste leitende Bahn mit den Fotowiderständen einer gleichen Zeile und jede zweite leitende Bahn mit den Fotowiderständen einer gleichen Spalte verbunden ist, und wobei der Schritt des Auswählens die folgenden Schritte aufweist:
Verbinden der ersten leitenden Bahn, die mit dem auszuwählenden Fotowiderstand verbunden ist, mit einer Quelle eines ersten Potentials (VDD);
Verbinden der anderen ersten leitenden Bahnen mit einer Quelle eines zweiten Potentials (GND), das sich von dem ersten Potential unterscheidet;
Verbinden der zweiten leitenden Bahn, die mit dem auszuwählenden Fotowiderstand verbunden ist, mit der Quelle des zweiten Potentials; und
Verbinden der anderen zweiten leitenden Bahnen mit der Quelle des ersten Potentials.

## Claims

1. An electromagnetic radiation detection device (90) comprising:
at least one row of photoresistors (45), each photoresistor comprising an active portion comprising organic semiconductor materials;
emitters (100) of the electromagnetic radiation and a waveguide (92) comprising at least one surface (94) intended to be in contact with at least one object, the photoresistors (45) being distributed along an edge (98) of said surface,
**characterized in that** the emitters are distributed along said edge and arranged alternatively with the photoresistors.

2. The detection device of claim 1, comprising an array of photoresistors (45) distributed in rows and in columns.

3. The detection device of claim 1 or 2, wherein each active portion (45) is connected to a first conductive electrode (38) and to a second conductive electrode (42).

4. The detection device of claim 3, wherein the work function of the first conductive electrodes (38) is equal to the work function of the second conductive electrodes (42) to within 5°.

5. The detection device of any of claims 1 to 4, comprising a monolithic layer (40) containing the active portions and extending between first conductive tracks (38) corresponding to the first electrodes and second conductive tracks (42) corresponding to the second electrodes.

6. The detection device of any of claims 1 to 5, further comprising display pixels (74).

7. A detection system (50) comprising the detection device (90) of any of claims 1 to 6, a circuit (56, 62) for selecting one of the photoresistors (45) and a circuit (64) for measuring the current flowing through the selected photoresistor or a voltage representative of the voltage across the selected photoresistor.

8. A method of controlling the electromagnetic radiation detection device (90) of any of claims 1 to 6, comprising selecting a photoresistor (45) from said at least one row and determining a signal representative of the resistance of the photoresistor.

9. The control method of claim 8, wherein the detection device comprises an array of photoresistors (45) distributed in rows and in columns, first conductive tracks (38) and second conductive tracks (42), each first conductive track being connected to the photoresistors of a same row and each second conductive track being connected to the photoresistors of a same column, and wherein the selection step comprises the steps of:
connecting the first conducting track connected to the photoresistor to be selected to a source of a first potential (VDD) ;
connecting the other first conductive tracks to a source of a second potential (GND) different from the first potential;
connecting the second conductive track connected to the photoresistor to be selected to the source of the second potential; and
connecting the other second conductive tracks to the source of the first potential.
